# EUROPEAN PATENT APPLICATION

(11) **EP 2 442 354 A1**
(43) Date of publication of application: **18.04.2012**
(21) Application number: 10786130.4
(22) Date of filing: 07.06.2010
(51) Int. Cl.: H01L 21/56, B60R 16/02, G01P 15/08, H01L 23/04, H05K 3/28

(54) **METHOD OF PRODUCING ELECTRONIC MODULE, AND ELECTRONIC MODULE**

(30) Priority: 11.06.2009 JP 2009139842
(71) Applicant: Sinfonia Technology Co., Ltd., Tokyo 105-8564 (JP)
(72) Inventor: KATADA, Hidetoshi, Ise-shi Mie 516-8550 (JP); KAWASE, Shoji, Ise-shi Mie 516-8550 (JP)
(74) Representative: TBK
(86) International application number: PCT/JP2010/059596
(87) International publication number: WO 2010/143599

(57) **Abstract**

Disclosed is a method of producing an electronic module, wherein vibration resistance with respect to vibration, strength with respect to impact, and waterproofness are all secured, production costs are reduced, and production steps are made simpler. The method produces an electronic module (1) including an electronic part (2) and a mounting part (3) for mounting the module to an outside part and includes a step of using a die (Di), which includes a cavity (Co) which holds sealing resin (4) and is open to the outside, and disposing the electronic part (2) in the cavity (Co) of the die (Di) before or after the sealing resin (4) flows in, a step of disposing the mounting part (3) in a way that secures the positional relationship with respect to the die (Di) so that a portion of the mounting part (3) (U-shaped part 3b) is positioned in the cavity (Co) and the other portion (the flange part 3a) projects from the cavity (Co) to the open side, a step of making the sealing resin (4) flow into the cavity (Co) of the die (Di), a step of curing the sealing resin (4) in a state in which the electronic part (2) and a portion of the mounting part (3) (the U-shaped part) are immersed in the sealing resin (4) which has flowed into the cavity (Co) of the die (Di), and a step of extracting the cured sealing resin (4) from the die (Di). The electronic module (1) is thereby produced.

## Description

### Technical Field

The present invention relates to a method of producing an electronic module which has an electronic part and a mounting part for fixing the module to an outside part, and to the electronic module.

### Background Art

An electronic module such as an acceleration sensor, an inclination sensor, etc. commonly has an electronic part which includes an electronic component part or a substrate with an electronic component part mounted thereon, and a mounting part for fixing the module to an outside part such as a vehicle frame. In the case of applying the electronic module to a vehicle such as an automobile, it is required to secure vibration resistance with respect to vibration of the vehicle, strength with respect to impact, and waterproofness, and to reduce production costs.

As an example of securely providing an electronic module with waterproofness, Patent Document 1 discloses an electronic module in which an electronic component part mounted on a flexible substrate is thinly coated with resin. This electronic module is produced by a simple production method in which the electronic component part is thinly coated with resin.

As an example of securely providing an electronic module with strength with respect to impact from the outside, Patent Document 2 discloses an electronic module in which a casing for containing an electronic component part and a substrate therein is integrally molded from resin together with a mounting part and an electric connector, whereby an electronic part is disposed inside the integrally molded casing. In this example, waterproofness is secured by enhancing the sealing properties of the casing.

As another example of securely providing an electronic module with waterproofness, Patent Document 3 discloses an electronic module wherein an electronic component part and an electric connector with the electronic component part mounted thereon are sealed with resin by injection molding or the like, while using a closed type die in which a space for holding the resin is closed.

The electronic modules disclosed in Patent Documents 2 and 3 are each commonly produced by use of a closed type die in which a space for holding a resin is in a closed state at the time of curing the resin.

### Prior Art Documents

### Patent Documents

Patent Document 1: Japanese Patent Laid-open No. 2006-108361
Patent Document 2: Japanese Patent Laid-open No. 2001-214776
Patent Document 3: PCT Patent Publication No. WO 2005/004563

### Summary of Invention

### Technical Problem

Meanwhile, in regard of an electronic module applied to a vehicle such as an automobile, it is required to secure vibration resistance with respect to vibration of the vehicle, strength with respect to impact, and waterproofness, and to lower the production cost. However, the electronic module disclosed in Patent Document 1 has a configuration in which an electronic component part is only coated with resin. Although the production method is simple, therefore, this electronic module has a problem in that strength with respect to impact, for example, upon contact therewith of a thing such as a falling object, and mounting strength may be insufficient, so that the electronic module may be broken, depending on the magnitude of the impact or vibration.

Besides, in the electronic modules disclosed in Patent Documents 2 and 3, a closed type die in which a space for holding a resin is closed is used, and a die conformed to the shapes of a mounting part and an electric connector is fabricated. Therefore, high accuracy is required for fabrication of the die, and the die must be re-fabricated a plurality of times, taking into account the deformation of the resin under thermal influences. Thus, these electronic modules have led to an increase in die fabrication cost and, hence, to an increase in the production cost.

In addition, when each of the above-mentioned conventional electronic modules is applied to a vehicle which is put into vibration, the following problem may be generated. Since the mounting part and the casing are integrally molded from resin, a thermal stress due to thermal influences is generated in the mounting part, so that the mounting part is liable to be displaced. If the electronic module is mounted with the mounting part in a displaced state, the mounting part may be broken due to vibration. Thus, mounting strength may be insufficient.

The present invention has been made paying attention to the above-mentioned problems. Accordingly, it is an object of the present invention to provide an electronic module wherein vibration resistance with respect to vibration, strength with respect to impact, and waterproofness are all secured and production costs are lowered, and a method of producing an electronic module wherein production steps are simplified.

### Technical Solution

In order to attain the above object, the present invention provides the following means.

According to the present invention, there is provided a method of producing an electronic module having an electronic part and a mounting part for mounting the module to an outside part, the method including: an electronic part setting step of using a die, which has a cavity which holds sealing resin and is open to the outside, and disposing the electronic part in the cavity of the die before or after the sealing resin flows in; a mounting part setting step of disposing the mounting part in a way that secures a positional relationship with respect to the die so that a portion of the mounting part is positioned in the cavity and an other portion of the mounting part projects from the cavity to the outside; a resin introducing step of making the sealing resin flow into the cavity of the die; a curing step of curing the sealing resin in a state in which the electronic part and a portion of the mounting part are immersed in the sealing resin which has flowed into the cavity of the die; and a die removing step of extracting the cured sealing resin from the die.

The form, production method, material and the like regarding the die do not matter, insofar as the die is formed with a cavity which is open to the outside so as to hold a sealing resin therein. Examples of the die which can be used include dies in which a cavity is formed by combining a plurality of die pieces together by use of bolts or the like, dies in which a cavity is formed by shaving, and dies in which the entire die body is integrally molded together with a cavity by injection molding or the like. As a method of producing the die having the cavity as just-mentioned, other various working methods than these methods can be applied.

According to this production method, the sealing resin is cured in a state in which the electronic part is immersed in the sealing resin, and the die is removed to expose the sealing resin to the outside. This ensures that the need for a casing can be eliminated, molding of a casing that is high in production cost due to the necessity for high accuracy can be omitted, and production costs can be thereby reduced.

Further, while a closed type die in which a space for holding a resin therein is closed is used in the prior art, an open type die in which a cavity for holding a sealing resin therein is open is used and an electronic part and a mounting part are only immersed in the sealing resin from the open side of the cavity of the die in the present invention. In the present invention, therefore, it suffices for the die to be able to hold the sealing resin therein, so that the same die can be reused even upon changes in the shapes of the mounting part and an electric connector. In addition, the need for accuracy of the die is eliminated, and the production cost can be reduced remarkably.

Furthermore, while a mounting part and a casing are integrally molded from resin in the prior art, a mounting part preliminarily fabricated separately from the sealing resin is used in the present invention. Besides, in the present invention, a portion of the mounting part projects to the outside of the resin, and the positional relationship between the mounting part and the die is secured. This ensures that a stress due to thermal influence is not liable to act on the projecting portion of the mounting part since the portion is located outside the resin. Accordingly, it is possible to prevent the mounting part from being displaced by the securing, to remarkably restrain the mounting part from being broken due to vibration, and to enhance the mounting strength.

The electronic part includes at least one of an electronic component part and a substrate. The substrate here includes a substrate, a printed circuit board, and a substrate having an electronic component part mounted thereon.

In order to guard the electronic part and thereby to enhance strength with respect to impact, it is effective that the curing step includes curing the sealing resin in a state in which the mounting part is disposed at such a position as to cover a portion of the electronic part.

In order to simplify the operation of disposing the electronic part in the cavity of the die, the electronic part setting step preferably includes disposing the electronic part so that the electronic part is engaged with an engagement part which is provided at the mounting part and restricts displacement of the electronic part.

In order to realize a mounting part which is easy to work, is insusceptible to thermal influences of resin and is durable to vibration, the production method according to the present invention may, for example, further includes a mounting part forming step of integrally forming the mounting part and the engagement part by metal working.

The metal working includes at least any of cutting, cutting-off, bending, press working, sheet metal working, molding and welding which are applied to a metallic body. The sheet metal working here includes at least any of blanking, cutting-off by laser or the like, cutting, bending, and joining such as welding which are applied to sheet metal.

An electronic module suitable for carrying out the method of producing the electronic module as above is specified as described below.

The electronic module according to the present invention includes an electronic part and a flange part for fixing the module to an outside part, wherein a metallic mounting part having the flange part is formed, a portion of the mounting part is disposed so as to cover at least a portion of the electronic part, and the electronic part and the mounting part covering the electronic part are coated with a sealing resin.

According to this configuration, the mounting part having the flange part is made of metal, whereby mounting strength with respect to vibration is enhanced remarkably, and the mounting part is so disposed as to cover at least a portion of the electronic part. Therefore, the electronic part can be guarded from impact of a falling object or the like. In addition, the electronic part and the mounting part are coated with the sealing resin, so that waterproofness can be secured while minimizing the amount of the resin needed. Consequently, a useful electronic module having these advantages can be provided.

### Advantageous Effect

The present invention is configured as above-described. According to the present invention, therefore, an open type die having a cavity which holds a sealing resin therein and is open to the outside is used, and the sealing resin is cured in a state in which the electronic part and a portion of the mounting part are immersed in the sealing resin. This ensures that vibration resistance with respect to vibration, strength with respect to impact, and waterproofness can all be secured, production costs can be lowered, and simpler production steps can be realized.

### Brief Description of Drawings

[FIG. 1]

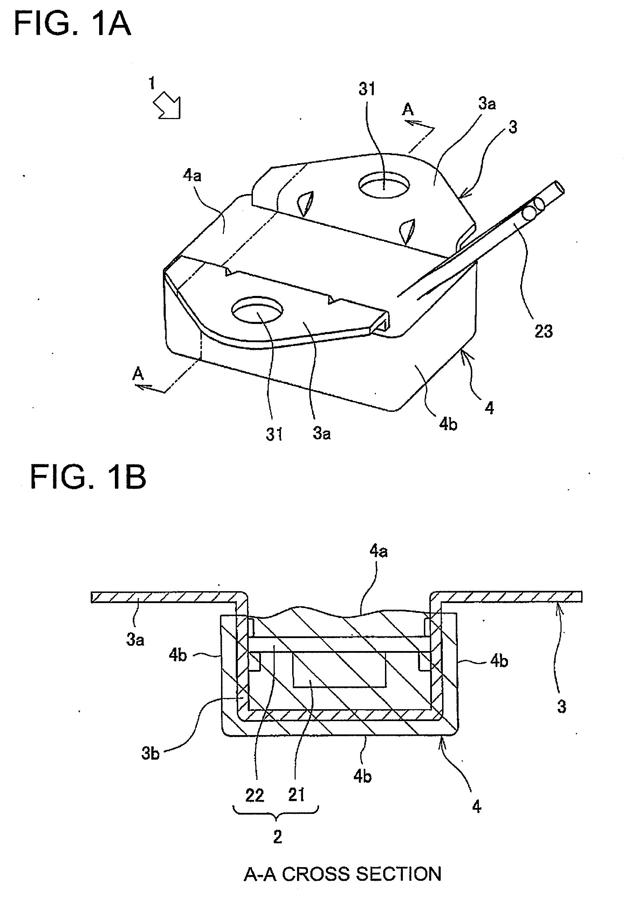

   FIG. 1 shows a perspective view and a sectional view for illustrating the structure of an electronic module according to an embodiment of the present invention which is produced by a method of producing an electronic module according to the present invention.
[FIG. 2]

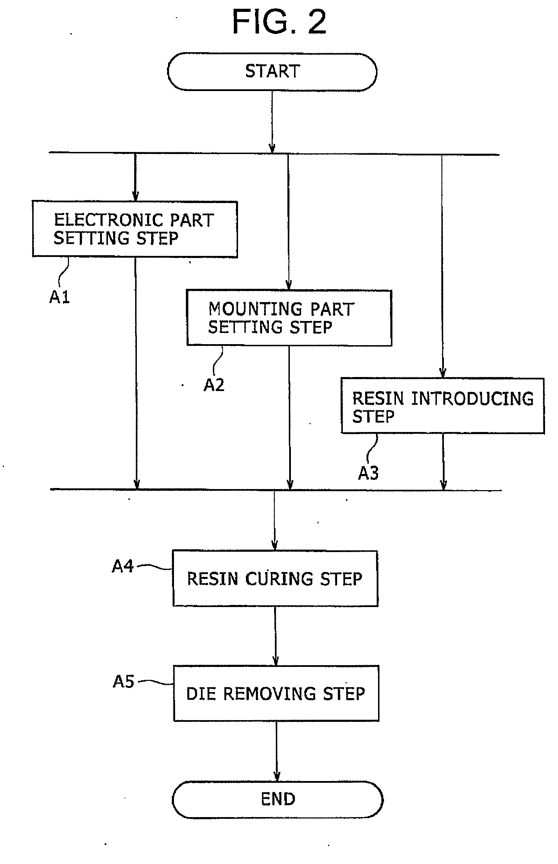

   FIG. 2 is a flow chart illustrating steps of the method of producing the electronic module according to the present invention.
[FIG. 3]

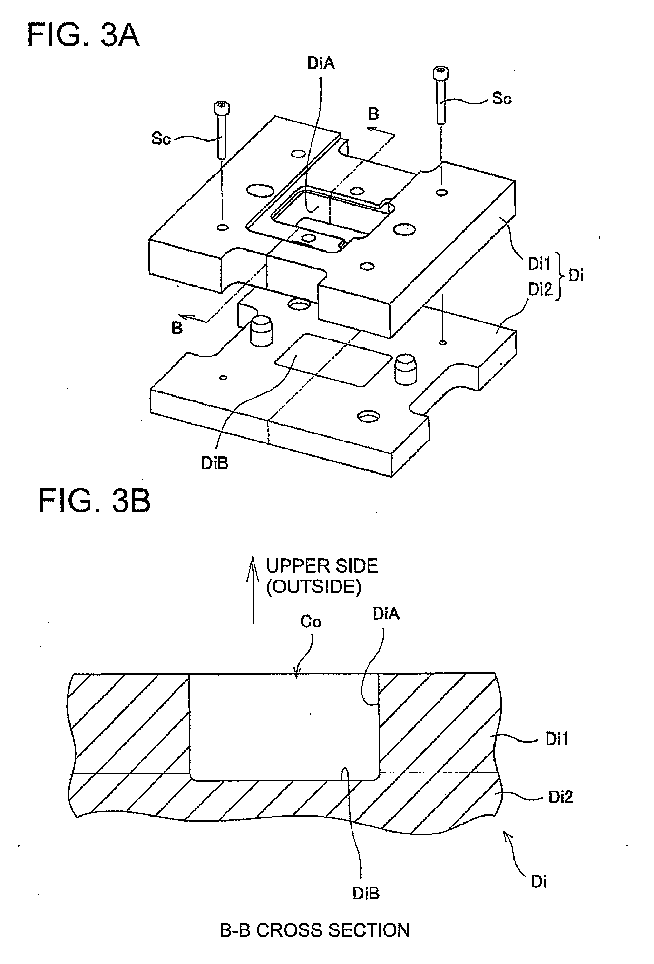

   FIG. 3 shows a perspective view and a sectional view for illustrating one step of the production method.
[FIG. 4]

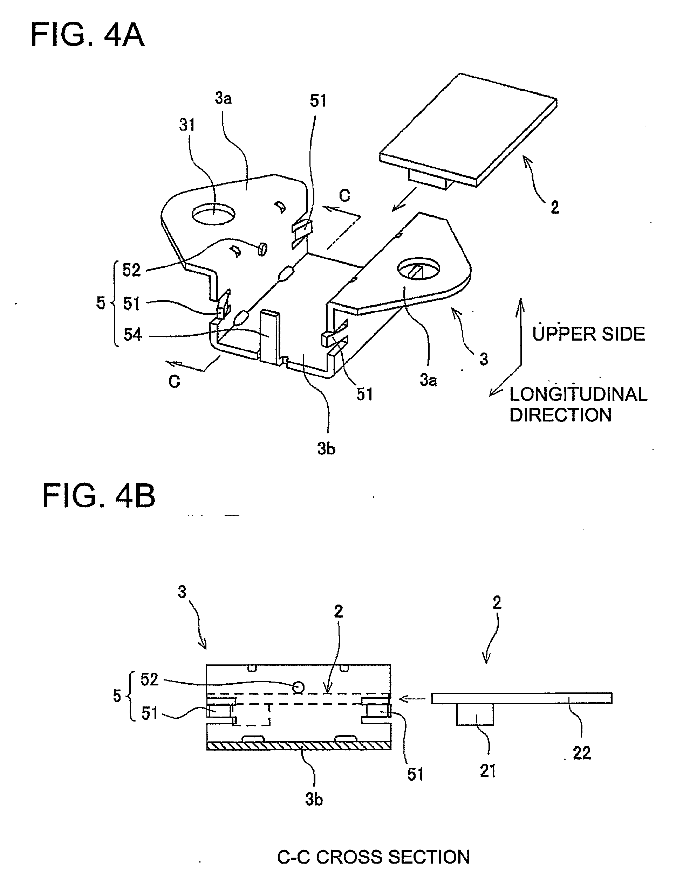

   FIG. 4 shows a perspective view and a sectional view for illustrating one step of the production method.
[FIG. 5]

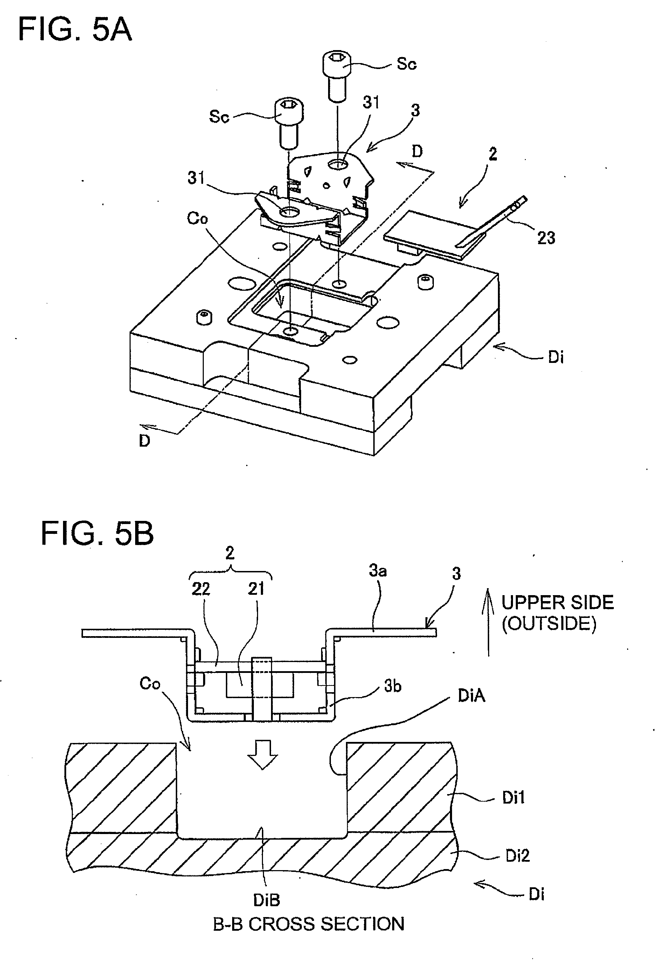

   FIG. 5 shows a perspective view and a sectional view for illustrating one step of the production method.
[FIG. 6]

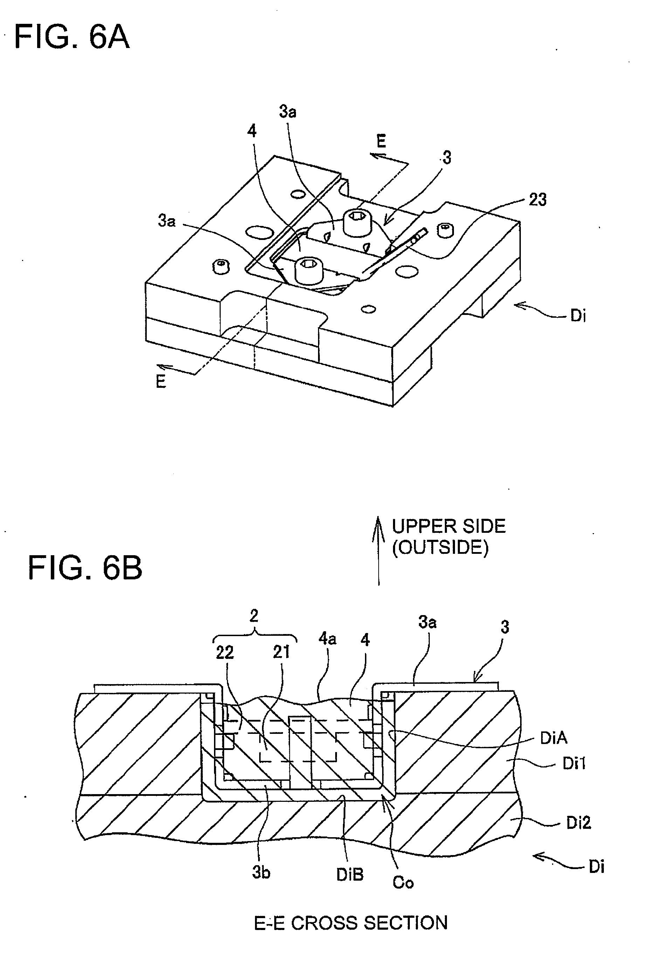

   FIG. 6 shows a perspective view and a sectional view for illustrating one step of the production method.
[FIG. 7]

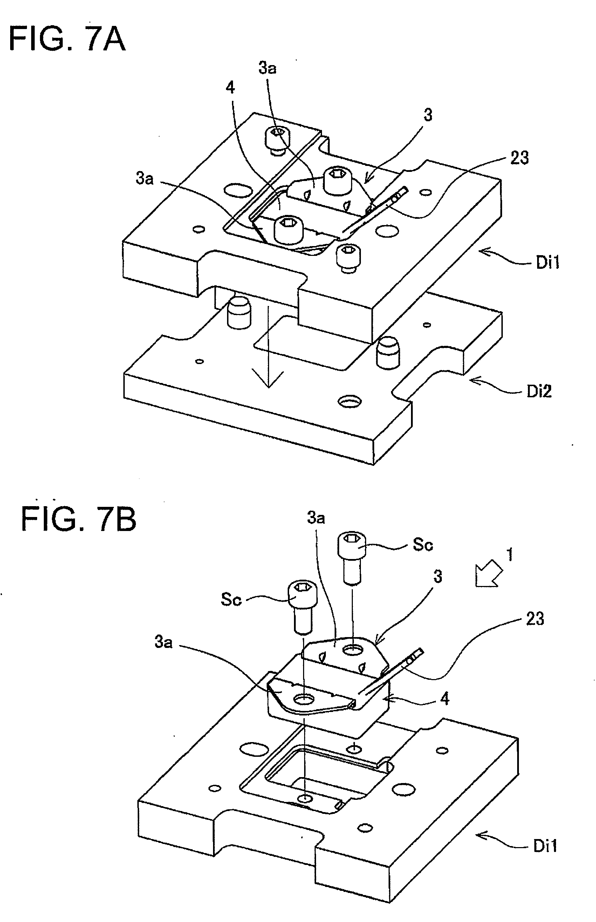

   FIG. 7 shows a perspective view and a sectional view for illustrating one step of the production method.
[FIG. 8]

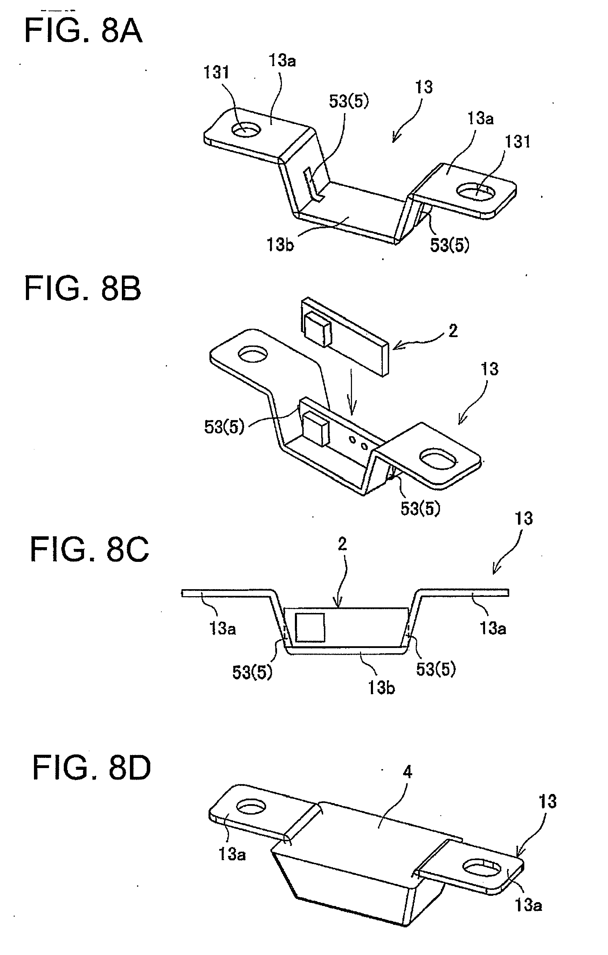

   FIG. 8 shows perspective views and a plan view for illustrating the structure of an electronic module according to another embodiment of the present invention.

### Mode for Carrying Out the Invention

Now, a method of producing an electronic module according to the present invention will be described below, in consideration of the drawings.

The method of producing an electronic module according to the present invention is a production method for producing an accelerator sensor to be mounted on a vehicle such as an automobile, specifically, an electronic module 1 which, as shown in FIG. 1A and FIG. 1B, includes an electronic part 2 including an electronic part 21 and a substrate 22 with the electronic part 21 mounted thereon, a mounting part 3 for fixation to an outside part such as a vehicle frame, and sealing resin 4 for sealing in a covering state in which the electronic part 2 and a portion of the mounting part 3 are embraced, wherein an electric connector part 23 for electrically connecting the electronic part 2 with an outside part is included of lead wires.

The mounting part 3 is formed by subjecting a high-rigidity metal such as a single sheet metal to sheet metal working such as blanking, cutting-off by laser or the like, cutting, bending, or joining such as welding, and has a pair of flange parts 3a exposed from the sealing resin 4 and a U-shaped part 3b covered with the sealing resin 4. The flange parts 3a are formed in the form of a pair of plates which are located substantially on the same plane so as to make contact with an outside part and be fixed thereto appropriately, and each of the plate-formed portions is formed with an insertion hole 31. The U-shaped part 3b is in the shape of projecting, between the pair of flanges parts 3a, from the plane on which the flange parts 3a are located toward one side so as to be substantially U-shaped in section. The electronic part 2 is disposed so as to be surrounded by the projecting portion, and the U-shaped part 3b of the mounting part 3 is disposed at a position for covering a portion of the electronic part 2, whereby the electronic part 2 is guarded from three directions.

As the sealing resin 4, an epoxy resin is used. The sealing resin 4 is introduced, together with the electronic part 2 and the mounting part 3, into a cavity Co of a metallic die Di for holding the sealing resin 4 shown in FIG. 3A and FIG. 3B, and is cured. Consequently, as shown in FIG. 1B, the U-shaped part 3b as a portion of the mounting part 3 and the electronic part 2 are sealed in a state in which the U-shaped part 3b and the electronic part 2 are embraced in the sealing resin 4. After the sealing resin 4 is cured, the die Di is removed, resulting in that all surfaces of the sealing resin 4 are exposed to the outside. Of the exposed surfaces of the sealing resin 4, some are well-shaped surfaces 4b which are well-shaped by curing in the state of making contact with the cavity Co of the die Di for holding the sealing resin 4, while the other is a non-well-shaped cured surface 4a having undergone expansion or contraction under thermal influences by curing in the state of not making contact with the cavity Co of the die Di. The flange parts 3a of the mounting part 3 and the electric connector part 23 are exposed from this cured surface 4a.

Now, the production method for producing the above-mentioned electronic module 1 will be described below, in consideration of FIGS. 2 to 7. As shown in FIG. 2, the production method in the present embodiment includes an electronic part setting step (A1), a mounting part setting step (A2), a resin introducing step (A3), a resin curing step (A4), and a die removing step (A5). Incidentally, in the following, a process in which the electronic part setting step (A1) and the mounting part setting step (A2) and the resin introducing step (A3) are sequentially conducted will be described as an example; however, the order in which to carry out these three steps can be changed freely.

First, as shown in FIG. 3A, an upper die Di1 and a lower die Di2 are fixed together by use of screws Sc, to assemble and prepare one die Di. As shown in FIG. 3B, the die Di is formed with a cavity Co which is defined by a hole peripheral side wall DiA of the upper die Di1 and an upper surface DiB of the lower die Di2 and holds a sealing resin 4 therein. The cavity Co is open to the outside (upper side).

Next, a mounting part 3 shown in FIG. 4A is formed by subjecting a high-rigidity metal such as a single sheet metal to sheet metal working such as blanking, cutting-off by laser or the like, cutting, bending, or joining such as welding (mounting part forming step). The mounting part 3 has a U-shaped part 3b which is a part to be sealed in the sealing resin 4 and is formed to be U-shaped in section, and a pair of flange parts 3a which are provided at both side ends of the U-shaped part 3b and are each formed with an insertion hole 31. The U-shaped part 3b is provided with an engagement part 5 for making contact with the electronic part 2 so as to restrict displacement of the electronic part 2. The engagement part 5 is composed of four claw parts 51 bend to the inside of the U-shaped part 3b, two projections 52 projecting to the inside of the U-shaped part 3b, and a flow stop part 54 projecting upward from one end portion in the longitudinal direction of the U-shaped part 3b. The claw parts 51 restricts downward displacement of the electronic part 2, whereas the projections 52 restrict upward displacement of the electronic part 2, and the flow stop part 54 restricts displacement in one sense of the longitudinal direction of the electronic part 2. The engagement part 5 composed of these parts constitutes the mounting part 3 of a type in which the electronic part is laid horizontally.

Subsequently, as shown in FIG. 4A and FIG. 4B, the electronic part 2 is slidingly inserted into a space between the claw parts 51 and the projections 52 which are provided at the U-shaped part 3b of the mounting part 3, whereby the electronic part 2 is set in the mounting part 3.

Next, as shown in FIG. 5A and FIG. 5B, the mounting part 3 with the electronic part 2 set therein is disposed in the cavity Co of the die Di, and is screwed to the die Di by screws Sc through the insertion holes 31 of the mounting part 3, whereby the positional relationship of the mounting part 3 and the die Di is fixed. In this instance, the U-shaped part 3b of the mounting part 3 and the electronic part 2 are in a floating state inside the cavity Co so that the U-shaped part 3b and the electronic part 2 can be entirely covered with the sealing resin 4. In addition, the electronic part 2 and the U-shaped part 3b of the mounting part 3 are located inside the cavity Co, whereas the flange parts 3a of the mounting part 3 and the electric connector part 23 are exposed from the open side of the cavity Co. Thus, the electronic part setting step (A1) and the mounting part setting step (A2) shown in FIG. 2 are carried out substantially simultaneously.

Subsequently, as shown in FIG. 6A and FIG. 6B, the sealing resin 4 is made to flow from the open side (upper side) of the cavity Co of the die Di into the cavity Co of the die Di (the resin introducing step A3 shown in FIG. 2). It suffices for the sealing resin 4 to be a little fluid to such an extent that the electronic part 2 and the U-shaped part 3b of the mounting part 3 can be surrounded by and immersed in the sealing resin 4. It is unnecessary to bring the sealing resin to such a high temperature that the lead wires of the electric connector part 23 would be burned, for the purpose of securing a high fluidity corresponding to a closed type die used in injection molding or the like as in the prior art. In the present embodiment, the temperature, depending on the quality of the sealing resin 4, suffices around 10°C. Then, the die Di is placed in a thermostat so as to cure the sealing resin 4 which has flowed into the cavity Co of the die Di (the curing step A4 shown in FIG. 2).

Finally, as shown in FIG. 7A, after the sealing resin 4 is cured, the upper die Di1 and the lower die Di2 are separated from each other, and the cured sealing resin 4 is extracted from the die Di, to complete the production of the electronic module 1 (the die removing step A5 shown in FIG. 2).

As above-mentioned, the method of producing an electronic module 1 according to the present embodiment produces an electronic module including an electronic part 2 and a mounting part 3 for fixation to an outside part and includes: an electronic part setting step (A1) for using a die Di, which includes a cavity Co which holds sealing resin 4 and is open to the outside, and disposing the electronic part 2 in the cavity Co of the die Di before or after the sealing resin 4 flows in; a mounting part setting step (A2) for disposing the mounting part 3 in a way that secures the positional relationship with respect to the die Di so that a portion of the mounting part 3 (U-shaped part 3b) is positioned in the cavity Co and the other portion (flange parts 3a) projects from the cavity Co to the open side; a resin introducing step (A3) for making the sealing resin 4 flow into the cavity Co of the die Di; a curing step (A4) for curing the sealing resin 4 in a state in which the electronic part 2 and a portion of the mounting part 3 (the U-shaped part 3b) are immersed in the sealing resin 4 which has flowed into the cavity Co of the die Di; and a die removing step (A5) for extracting the cured sealing resin 4 from the die Di.

According to this production method, the sealing resin 4 is cured in the state in which the electronic part 2 is immersed in the sealing resin 4, and the die Di is removed so that the sealing resin 4 is exposed to the outside. Therefore, the need for a casing can be eliminated, the molding of a casing which is high in production cost due to the need for high accuracy can be omitted, and production costs can be thereby reduced.

Further, in the prior art, a closed type die in which a space for holding a resin is closed is used. In the present embodiment, on the other hand, an open type die Di in which the cavity for holding the sealing resin 4 is open is used, and the electronic part 2 and the mounting part 3 are only immersed in the sealing resin 4 from the open side of the cavity Co of the die Di. Therefore, it suffices for the cavity Co to be able to hold the sealing resin 4 therein, so that the same die Di can be reused even upon changes in the shapes of the mounting part 3 and the electric connector part 23. Moreover, the need for accuracy of the die Di is eliminated, and production costs can be reduced remarkably.

Furthermore, in the prior art, the mounting part 3 and a casing are integrally molded from a resin. In the present embodiment, in contrast, the mounting part 3 preliminarily produced separately from resin molding is used, a portion of the mounting part 3 (flange parts 3a) is made to project to the outside of the resin, and the positional relationship between the mounting part 3 and the die Di is secured. This ensures that a stress due to thermal influence is not liable to act on the projecting portion of the mounting part 3 since the portion is outside the resin. Besides, the mounting part 3 can be prevented from being displaced by securing, the possibility of damage to the mounting part 3 due to vibration can be lowered markedly, and mounting strength can be enhanced.

In the present embodiment, in the curing step (A4), the sealing resin 4 is cured in the state in which the mounting part 3 is disposed at such a position as to cover a portion of the electronic part 2. Therefore, the electronic part 2 is guarded not only by the sealing resin 4 but also by the mounting part 3, so that strength with respect to impact can be enhanced.

Besides, in the present embodiment, in the electronic part setting step (A4), the electronic part 2 is disposed in the state of being engaged with the engagement part 5 which is provided on the mounting part 3 and restricts displacement of the electronic part 2. Therefore, disposing the mounting part 3 in relation to the die Di is spontaneously attended by disposition of the electronic part 2 in relation to the die Di. Accordingly, the operation of disposing the electronic part 2 in the cavity Co of the die Di can be facilitated.

In addition, in the present embodiment, a mounting part forming step is conducted in which the mounting part 3 and the engagement part 5 are integrally formed by metal working. Therefore, it is possible, by using metal working which is easy to carry out, to realize a mounting part which is free of thermal influences exerted from the resin and is high in durability to vibration.

The electronic module 1 produced by carrying out the method of producing the electronic module as above-described is an electronic module 1 which has the electronic part 2 and the flange parts 3a for fixation to an outside part. The electronic module 2 is **characterized in that** the metallic mounting part 3 having the flange parts 3a is formed, a portion of the mounting part 3 (the U-shaped part 3b) is so disposed as to cover at least a portion of the electronic part 2, and the electronic part 2 and the mounting part 3 (the U-shaped part 3b) covering the electronic part 2 are covered with the sealing resin 4.

According to this configuration, the mounting part 3 having the flange parts 3a is formed from a metal, whereby mounting strength with respect to vibration can be enhanced conspicuously. In addition, since the mounting part 3 is so disposed as to cover at least a portion of the electronic part 2, the electronic part 2 can be guarded against impacts of a falling object and the like. Further, since the electronic part 2 and the mounting part 3 are covered with the sealing resin 4, waterproofness can be secured while minimizing the amount of resin needed. Consequently, a useful electronic module having these advantages can be provided.

Incidentally, where a closed type die is used as in the prior art, the shape of the resin formed by resin molding can be freely set. Therefore, this is a molding method which can be adopted in application examples where an increase in production cost does not matter. In the present embodiment, however, the shape of the resin does not matter, insofar as strength, waterproofness and vibration resistance can be secured. Consequently, it is possible to adopt an open type die in which it suffices that the electronic part 2 and the mounting part 3 are immersed in the resin.

Besides, in the prior art, a closed type die is used and, therefore, the resin temperature would reach such a high temperature that lead wires are burned, at the time of molding. This leads to that the lead wires cannot be adopted for the electric connection part for electric connection between an outside part and the electronic part, and metallic pins which are resistant to heat have to be adopted. Thus, it has been a common practice to configure an electric connector of a fitting type in which metallic pins are used to thereby facilitate connection with an outside part. Use of a fitting type electric connector makes it necessary to insure that the electric connector can be connected to the same type of electric connector, which leads to strict accuracy in aligning the die to the positions of the pins. For this reason, there has been an increase in the production cost of the closed type die. In the present embodiment, on the other hand, lead wires can be adopted for the electric connection part for electric connection between an outside part and the electronic part. Accordingly, it is also possible, by attaching a commercial electric connector to the lead wires, to remarkably lower the production costs.

In addition, in the present embodiment, the mounting part 3 having a plurality of flange parts 3a is made of metal, so that the positional relationship between the flange parts 3a is invariable, and the mounting part 3 is supported at a plurality of points for which the positional relationship is secured. Therefore, mounting strength with respect to vibration can be enhanced remarkably. Naturally, the number of the flange parts 3a is not limited to two.

While embodiments of the present invention have been described above based on the drawings, specific configurations are to be construed as not restricted to these embodiments. The scope of the present invention is not shown only by the description of the embodiments above but is shown by the scope of the claims, and, further, all modifications within the meaning and scope equivalent to the scope of the claims are included therein.

For instance, as shown in FIGS. 8A to D, a mounting part 13 of a type in which the electronic part is laid out vertically may be adopted in which a mounting part 13 is composed of flange parts 3a each formed with an insertion hole 31 and a U-shaped part 3b, like the above-mentioned mounting part 3, an engagement part 5 is included of slits 53, instead of the engagement part 5 included of the claw parts 51 and the projections 52, and the electronic part 2 is inserted in the slits 53 to thereby restrict displacement of the electronic part 2. In addition, the U-shaped part 13b of the mounting part 13 may be provided with a gradient. Besides, as shown in FIG. 8D, a surface or surfaces of the sealing resin 4 may be inclined so as to permit the sealing resin 4 to be easily extracted from the die Di.

In addition, while the electronic module 1 is assumed to be an acceleration sensor to be mounted on a vehicle such as an automobile in the present embodiment, the present invention is applicable to anything that includes an electronic part, which includes a substrate with an inclination sensor or other electronic part mounted thereon, and a mounting part.

Further, while a single kind of resin is used as the resin material of the sealing resin 4 in the present embodiment, a plurality of kinds of resins or a mixed resin obtained by mixing these resins may be used.

Furthermore, while the resin introducing step of making the sealing resin 4 to flow in and the curing step of curing the sealing resin 4 are each conducted once and the sealing resin 4 is composed of one cured layer in the present embodiment, these steps may each be carried out a plurality of times so that the sealing resin 4 is composed of a plurality of cured layers, or the sealing resin 4 may be formed by stacking another cured layer on the original cured layer. In addition, the cured layer which has been once cured may be immersed in another resin to be coated with the another resin, and such an operation may be repeated a plurality of times (twice, trice, and so on), to obtain a multiple-coating structure. Thus, the number of times the resin introducing step and the curing step are carried out and/or the shape of the sealing resin 4 formed can be changed variously.

In addition, while the electronic part 2 includes the electronic part 21 and the substrate 22 having the electronic part 21 mounted thereon in the present embodiment, the electronic part 2 may include at least one of the electronic part and the substrate. The substrate here include a substrate, a printed circuit board, and a substrate having an electronic part or parts mounted thereon.

Further, while a step of subjecting a single high-rigidity sheet metal to sheet metal working such as blanking, cutting-off by laser or the like, cutting, bending, or joining such as welding is conducted as a step of forming the mounting part 3 in the present embodiment, other metallic body than sheet metal may be subjected to metal working such as forming or cutting to form the mounting part 3. Examples of such metal working include cutting, cutting-off, bending, press working, sheet metal working, molding, and welding which are applied to a metallic body. Among these metal working operations, sheet metal working is particularly suitable from the viewpoint of workability and production cost. Other operation than metal working may also be adopted insofar as the operation is comparable to metal working in workability and production cost.

Furthermore, while a plurality of die pieces such as the upper die Di1 and the lower die Di2 are assembled by use of bolts or the like to obtain the single die Di formed with the cavity Co in the present embodiment, examples of the die include dies in which a cavity Co is formed by shaving, and dies in which the entire die body is integrally molded together with a cavity Co by injection molding or the like. The direction in which the die pieces are combined together is not limited to the upper-lower direction. As the production of the die having the cavity Co as above, other various working methods than the above-mentioned can be applied.

Besides, specific configurations of parts are not restricted only to those in the above-described embodiments, and various modifications are possible within the scope of the gist of the present invention.

### Industrial Applicability

According to the present invention described in detail above, an open type die having a cavity which holds a sealing resin and is open to the outside is used and the sealing resin is cured in a state in which an electronic part and a portion of a mounting part are immersed in the sealing resin. This ensures that vibration resistance with respect to vibration, strength with respect to impact, and waterproofness can all be secured, production costs can be lowered, and simpler production steps can be realized.

## Claims

1. A method of producing an electronic module having an electronic part and a mounting part for mounting the module to an outside part, the method comprising:
an electronic part setting step of using a die, which has a cavity which holds sealing resin and is open to the outside, and disposing the electronic part in the cavity of the die before or after the sealing resin flows in;
a mounting part setting step of disposing the mounting part in a way that secures a positional relationship with respect to the die so that a portion of the mounting part is positioned in the cavity and an other portion of the mounting part projects from the cavity to the outside;
a resin introducing step of making the sealing resin flow into the cavity of the die;
a curing step of curing the sealing resin in a state in which the electronic part and a portion of the mounting part are immersed in the sealing resin which has flowed into the cavity of the die; and
a die removing step of extracting the cured sealing resin from the die.

2. The method of producing the electronic module according to claim 1, wherein the curing step includes curing the sealing resin in a state in which the mounting part is disposed as such a position as to cover a portion of the electronic part.

3. The method of producing the electronic module according to claim 1 or 2, wherein the electronic part setting step disposes the electronic part with the electronic part engaged with an engagement part which is provided at the mounting part and restricts displacement of the electronic part.

4. The method of producing the electronic module according to claim 1 or 2, further comprising a mounting part forming step of integrally forming the mounting part and the engagement part by metal working.

5. The method of producing the electronic module according to claim 3, further comprising a mounting part forming step of integrally forming the mounting part and the engagement part by metal working.

6. An electronic module comprising an electronic part and a flange part for fixing the module to an outside part, wherein
a metallic mounting part having the flange part is formed, a portion of the mounting part is disposed so as to cover at least a portion of the electronic part, and the electronic part and the mounting part covering the electronic part are coated with a sealing resin.
